# EUROPÄISCHE PATENTANMELDUNG

(11) **EP 0 780 691 A2**
(43) Veröffentlichungstag der Anmeldung: **25.06.1997**
(21) Anmeldenummer: 96810805.0
(22) Anmeldetag: 18.11.1996
(51) Int. Cl.: G01R 15/16

(54) **Sensor zum Auskoppeln von Teilentladungsimpulsen aus einer mehrphasigen hochspannungsführenden elektrischen Anlage**

(30) Priorität: 22.12.1995 DE 19548465
(71) Anmelder: ABB RESEARCH LTD., 8050 Zürich (CH)
(72) Erfinder: Behrmann, Glenn, 5708 Birrwil (CH)
(74) Vertreter: Liebe, Rainer

(57) **Zusammenfassung**

Dieser Sensor ist zum Auskoppeln von Teilentladungsimpulsen aus einer elektrischen Anlage, insbesondere einer metallgekapselten gasisolierten Schaltanlage, vorgesehen, deren Aktivteile hochspannungsbeaufschlagt sind. Der Sensor weist mindestens eine, dem jeweiligen Aktivteil der Anlage zugeordneten, dem elektromagnetischen Feld der Anlage ausgesetzten, Messelektrode auf und mindestens eine mit der Messelektrode verbundenen Signalverarbeitungsvorrichtung (28).

Es soll ein Sensor geschaffen werden, welcher sich in mehrphasig gekapselten Hochspannungsanlagen einsetzen lässt, welcher sich durch einen hohen Wirkungsgrad bei der Auskoppelung der in der Anlage auftretenden Teilentladungsimpulse und eine vergleichsweise hohe obere Grenzfrequenz auszeichnet, und welcher einfach zu montieren ist. Dies wird dadurch erreicht, dass die Aktivteile mindestens drei symmetrisch auf drei Achsen (2,3,4) angeordnete Phasenleiter (5,6,7) umfassen, dass die Messelektrode ringförmig ausgebildet ist und in mindestens drei identische, voneinander beabstandete, als Elektroden (9,10,11) ausgebildete Segmente aufgeteilt ist, von denen jedes einem der Phasenleiter (5,6,7) zugeordnet ist, dass jede der mindestens drei Elektroden (9,10,11) mit der Signalverarbeitungsvorrichtung (28) verbunden ist, und dass die Signalverarbeitungsvorrichtung (28) Mittel aufweist, für das Ausfiltern von den ausgekoppelten Teilentladungsimpulsen überlagerten Störungen.

## Beschreibung

### TECHNISCHES GEBIET

Bei der Erfindung wird von einem Sensor zum Auskoppeln von Teilentladungsimpulsen aus einer hochspannungsführenden elektrischen Anlage gemäss dem Oberbegriff des Anspruchs 1 ausgegangen. Insbesondere wird der Sensor in einer metallgekapselten gasisolierten Hochspannungsanlage eingesetzt. Der Sensor kann aber beispielsweise auch bei der Überwachung von Transformatoren, Hochspannungskabeln oder sonstigen spannungsführenden Baugruppen oder Anlagen eingesetzt werden.

### STAND DER TECHNIK

Die Erfassung von Teilentladungsimpulsen spielt bei der Überwachung von hochspannungsführenden elektrischen Anlagen, wie etwa einer metallgekapselten gasisolierten Hochspannungsanlage (GIS) oder einem hochspannungsbeaufschlagten elektrischen Gerät, beispielsweise einem Transformator oder einem Generator, eine wichtige Rolle. Teilentladungsmessungen werden sowohl während des Betriebs als auch bei der Qualitätskontrolle während der Fertigung in der Fabrik und auch bei der Qualitätsprüfung während des Vor-Ort-Aufbaus der metallgekapselten gasisolierten Schaltanlage oder des betreffenden Geräts durchgeführt.

Ein Sensor zum Auskoppeln von Teilentladungsimpulsen aus einer hochspannungsführenden elektrischen Anlage ist beispielsweise aus der Patentschrift EP 0 134 187 B1 bekannt. Der vorbekannte Sensor weist eine als Metallplatte ausgebildete Messelektrode auf, die in die innere Oberfläche der Metallkapselung einer gasisolierten metallgekapselten Hochspannungsanlage eingelassen ist, allerdings ist der Sensor von der Metallkapselung elektrisch isoliert. Die von dem Sensor aus dieser hochspannungsführenden Anlage kapazitiv ausgekoppelten Teilentladungsimpulse werden in einer dem Sensor nachgeschalteten Signalverarbeitungsvorrichtung weiter verarbeitet. Ein derartiger Sensor ist nicht in der Lage, die dem jeweiligen Teilentladungsimpuls überlagerten hochfrequenten Störungen zu erkennen und auszufiltern.

Aus der Offenlegungsschrift DE 42 21 865 A1 ist ein weiterer Sensor für die Erfassung von in einer metallgekapselten gasisolierten Schaltanlage (GIS) auftretenden Teilentladungsimpulsen bekannt. Die Messelektrode dieses Sensors ist als geschlossener, im Innern der Kapselung konzentrisch zu den Aktivteilen der Schaltanlage angeordneter Ring aufgebaut, sodass sich der Sensor inhärent wie ein abgestimmter Resonator verhält. Die obere Grenzfrequenz dieses Sensors liegt bei vergleichsweise niedrigen Frequenzwerten. Je grösser der Durchmesser dieses Ringsensors ist, desto länger wird die Laufzeit der Signale auf dem Sensor, und damit sinkt auch die obere Grenzfrequenz des Sensors ab. Bei diesem Sensor wird auch das stets überlagerte Hintergrundgeräusch nicht unschädlich gemacht.

### KURZE DARSTELLUNG DER ERFINDUNG

Der Erfindung, wie sie im Patentanspruch 1 definiert ist, liegt die Aufgabe zugrunde, einen Sensor zu schaffen, welcher sich in mehrphasig gekapselten Hochspannungsanlagen einsetzen lässt, welcher sich durch einen hohen Wirkungsgrad bei der Auskoppelung der in der Anlage auftretenden Teilentladungsimpulse und eine vergleichsweise hohe obere Grenzfrequenz auszeichnet, und welcher einfach zu montieren ist.

Mit dem erfindungsgemässen Sensor ist es möglich, mit hoher Genauigkeit zu erkennen, dass Teilentladungsimpulse in der metallgekapselten gasisolierten Schaltanlage auftreten, da diese vorteilhaft deutlich von den Geräuschsignalen unterschieden werden.

Der erfindungsgemässe Sensor weist ferner einen grossen Störabstand zu den in Hochspannungsanlagen auftretenden niederfrequenten Störungen auf.

Die weiteren Ausgestaltungen der Erfindung sind Gegenstände der abhängigen Ansprüche.

Die Erfindung, ihre Weiterbildung und die damit erzielbaren Vorteile werden nachstehend anhand der Zeichnung, welche lediglich einen möglichen Ausführungsweg darstellt, näher erläutert.

### KURZE BESCHREIBUNG DER ZEICHNUNG

Die einzige Figur zeigt in stark vereinfachter, schematischer Darstellung einen Schnitt durch eine mit einem erfindungsgemässen Sensor versehene, dreiphasig metallgekapselte gasisolierte Hochspannungsanlage.

Alle für das unmittelbare Verständnis der Erfindung nicht erforderlichen Elemente sind nicht dargestellt.

### WEGE ZUR AUSFÜHRUNG DER ERFINDUNG

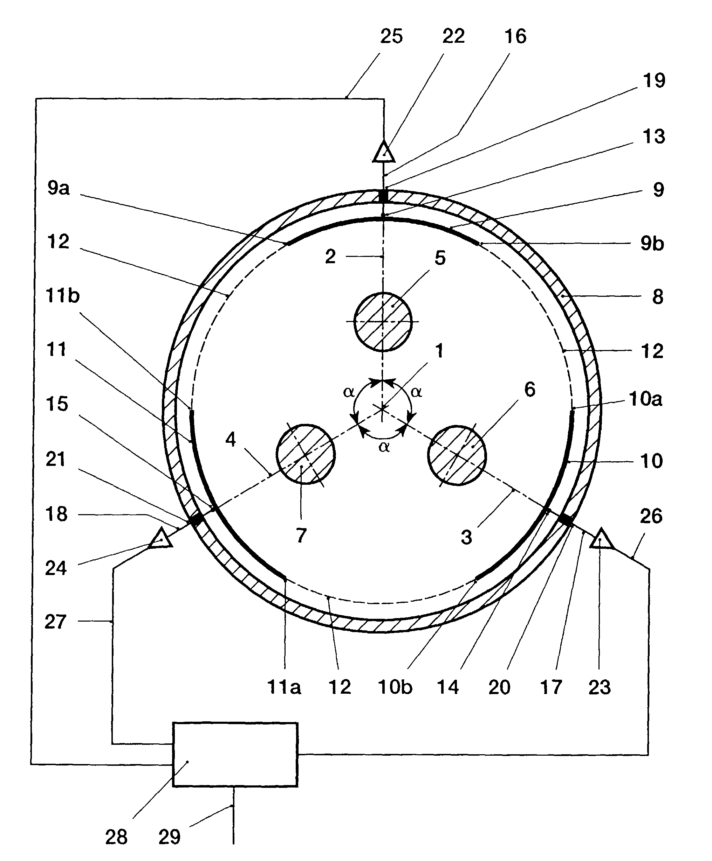

In der Fig.1 ist in stark vereinfachter, schematischer Darstellung ein Schnitt durch eine dreiphasig metallgekapselte gasisolierte Hochspannungsanlage dargestellt, welche mit einem Sensor für die Auskopplung von Teilentladungsimpulsen versehen ist. Diese Hochspannungsanlage weist ein Zentrum 1 auf, von dem drei um jeweils einen Winkel α versetzte, in einer Ebene, der Schnittebene, liegenden Achsen 2,3 und 4 ausgehen. Der Winkel α weist hier einen Wert von 120° auf. Auf jeder der Achsen 2,3 und 4 ist im gleichen Abstand vom Zentrum 1 ein, beispielsweise zylindrisch ausgebildeter, mit Hochspannung beaufschlagter Phasenleiter 5,6 und 7 angeordnet. Die Phasenleiter 5,6 und 7 erstrecken sich in einer Richtung senkrecht zu der Schnittebene, sie werden von nicht dargestellten Isolatoren getragen. Der Phasenleiter 5 ist der Achse 2, der Phasenleiter 6 ist der Achse 3 und der Phasenleiter 7 ist der Achse 4 zugeordnet. Der Phasenleiter 5 ist der Phase R zugeordnet, der Phasenleiter 6 ist der Phase S zugeordnet und der Phasenleiter 7 ist der Phase T zugeordnet. Konzentrisch um das Zentrum 1 und um die beschriebene Phasenleiter-Anordnung ist eine geerdete metallische Kapselung 8 angeordnet. Die Kapselung 8 ist mit einem Isoliergas, wie beispielsweise SF₆, unter Druck gefüllt. Im Inneren der Kapselung 8 sind drei identisch geformte, als Ringsegmente ausgebildete, elektrisch leitende Elektroden 9,10 und 11 in unmittelbarer Nähe der Kapselung 8, eventuell sogar in sie eingelassen, jedoch elektrisch isoliert von dieser, angeordnet. Die Elektrode 9 ist der Achse 2, die Elektrode 10 ist der Achse 3 und die Elektrode 11 ist der Achse 4 zugeordnet, wobei jede der Achsen 2,3 und 4 gleichzeitig die Symmetrieachse für die jeweils zugeordnete Elektrode bildet. Die Elektrode 9 weist Enden 9a und 9b auf, die Elektrode 10 weist Enden 10a und 10b auf, die Elektrode 11 weist Enden 11a und 11b auf. Zwischen den Elektroden 9,10 und 11 ist jeweils ein durch eine gestrichelt ausgeführte Linie angedeuteter Spalt 12 vorgesehen, sodass die drei Elektroden 9,10 und 11 elektrisch voneinander isoliert sind. Die Spalte 12 haben alle die gleichen Abmessungen. Hier sind beispielsweise drei identisch ausgebildete Elektroden 9,10 und 11 vorgesehen. Die Ausbildung der Elektroden 9,10 und 11 wird durch die erwartete Frequenz der zu erfassenden Teilentladungsimpulse bestimmt.

In der geometrischen Mitte der Elektroden 9,10 und 11 ist jeweils eine Anzapfung 13,14 und 15 vorgesehen, die mit jeweils einer Messleitung 16,17 und 18 verbunden ist. Die Messleitungen 16,17 und 18 werden jeweils mittels einer druckdichten Durchführung 19,20 und 21 aus der Kapselung 8 herausgeführt. Die Messleitungen 16,17 und 18 sind koaxial ausgebildet. Die Anzapfungen 13,14 und 15 werden dabei jeweils als Seele in das abgeschirmte Koaxialkabel eingeführt, um eine Beeinflussung der übertragenen Signale durch äussere Störsignale zu verhindern. Vorzugsweise wird hierfür jeweils ein abgeschirmtes 50Ω-Koaxialkabel verwendet. Unmittelbar nach dem Austritt aus der Kapselung 8 ist jede der drei Messleitungen 16,17 und 18 mit jeweils einem Vorverstärker 22,23 und 24 versehen, welcher die durch die Elektroden 9,10 und 11 aufgenommenen Signale verstärkt. Von jedem der drei Vorverstärker 22,23 und 24 führt eine koaxial abgeschirmte Leitung 25,26 und 27, vorzugsweise jeweils ein abgeschirmtes 50Ω-Koaxialkabel, in eine Signalverarbeitungsvorrichtung 28. Die drei abgeschirmten Leitungen 25,26 und 27 sind gleich lang ausgeführt, um etwaige Laufzeitunterschiede der Signale zu vermeiden. In der Signalverarbeitungsvorrichtung 28 werden die ankommenden Signale miteinander verarbeitet, das Resultat dieser Signalverarbeitung wird durch eine abgehende Leitung 29 in eine nicht dargestellte Erfassungseinrichtung für Teilentladungsimpulse abgeführt. In der Erfassungseinrichtung werden etwaige Teilentladungsimpulse registriert und gegebenenfalls wird von dieser Erfassungseinrichtung ein Alarmsignal generiert, um die Notwendigkeit einer Revision der Hochspannungsanlage anzuzeigen. Die Zuordnung der Bauelemente zu den einzelnen Phasen ist der Figur zu entnehmen.

Der Sensor kann auch noch weitere Ausführungsformen aufweisen, so können beispielsweise die Enden 9a und 9b, die Enden 10a und 10b und die Enden 11a und 11b der Elektroden 9,10 und 11 jeweils über jeweils ein Impedanzanpassungselement, welches als elektronisches Bauelement oder als ohmscher Widerstand ausgebildet ist, mit der Kapselung 8 elektrisch leitend verbunden sein. Der sonstige Aufbau des Sensors entspricht der in der Figur gezeigten Ausführungsform.

Bei einer weiteren Ausführungsform sind die Elektroden 9,10 und 11 geometrisch ähnlich ausgebildet wie in der Figur beschrieben, ihr innerer Aufbau unterscheidet sich jedoch grundlegend von den bisher beschriebenen Ausführungsformen. Die Elektroden 9,10 und 11 bestehen aus einem Material, welches an der Oberfläche für elektromagnetische Wellen eine unterschiedliche Leitfähigkeit aufweist, und zwar ist diese Leitfähigkeit an den Enden 9a,9b, bzw. 10a,10b, bzw. 11a,11b geringer als in der geometrischen Mitte der Elektroden 9,10 und 11, wobei die Leitfähigkeit für elektromagnetische Wellen von den Enden 9a,9b, bzw. 10a,10b, bzw. 11a,11b her zur Mitte hin stetig zunimmt. Die Zunahme der Leitfähigkeit kann wegen der besseren Ausführbarkeit auch stufenweise erfolgen. Die Elektroden 9,10 und 11 können auch einen gemeinsamen Ring aus Isoliermaterial als Träger aufweisen, der auf der den Phasenleitern 5,6 und 7 zugewandten Seite so beschichtet wird, dass die gewünschten unterschiedlichen Leitfähigkeitswerte für elektromagnetische Wellen erreicht werden. Der übrige Aufbau des Sensors ist gleich wie der bereits oben beschriebene. Derartig aufgebaute Elektroden 9,10 und 11 wirken ähnlich wie Antennendipole.

Es erweist sich als vorteilhaft, wenn in die Hochspannungsanlage mindestens zwei derartige Sensoren mit jeweils mindestens drei Elektroden 9,10 und 11 für die Auskopplung von Teilentladungsimpulsen eingebaut werden, da bei der Inbetriebsetzung der eine dieser Sensoren verwendet werden kann für die Einbringung von hochfrequenten Eichimpulsen, mit Hilfe dieser Eichimpulse kann dann der jeweils andere Sensor geeicht werden.

Die Geometrie der Elektroden 9,10 und 11 kann so angepasst werden, dass gezielt die für die angestrebten Einsatzbereiche des Sensors relevanten Frequenzbereiche besonders gut ausgekoppelt werden können.

Zur Erläuterung der Wirkungsweise wird nun die einzige Figur näher betrachtet. Der dargestellte Sensor ist vorgesehen für das Auskoppeln von Teilentladungsimpulsen aus einer hochspannungsführenden elektrischen Anlage, er arbeitet deshalb in einem Frequenzbereich von etwa 10 MHz bis etwa 1,5 GHz. Die genaue Bandbreite wird durch die geometrischen Abmessungen der Elektroden 9,10 und 11 bestimmt. Durch die Anpassung der Abmessungen der Elektroden 9,10 und 11 können bei Bedarf auch andere Frequenzbereiche eingestellt werden. Bei der Betriebsfrequenz der Hochspannungsanlage ist der Sensor nicht wirksam.

Wenn transiente elektromagnetische Felder, wie sie zum Beispiel durch hochfrequente Teilentladungsimpulse verursacht werden, in der durch den Sensor überwachten Hochspannungsanlage auftreten, so wandern sie durch diese Anlage. Häufig sind in einer Hochspannungsanlage mehrere Sensoren angeordnet, sodass der Ort der Teilentladungsquelle relativ gut eingegrenzt werden kann, sodass zur Fehlerbeseitigung nur ein vergleichsweise kleiner Teil der Anlage demontiert werden muss.

Die drei Elektroden 9,10 und 11 des Sensors werden beim Auftreten von hochfrequenten Teilentladungsimpulsen durch das im Innern der Kapselung 8 herrschende elektrische Feld beaufschlagt, wenn ein entsprechender identischer Aufbau dieser Elektroden 9,10 und 11 vorausgesetzt wird, und zwar in genau gleicher Weise, jedoch, entsprechend den unterschiedlichen Spannungsbeaufschlagungen beim Dreiphasennetz, zeitlich versetzt. Jede der drei Elektroden 9,10 und 11 nimmt dabei ein entsprechendes kapazitives, vom elektrischen Feld herrührendes Signal auf. Im Normalbetrieb der Hochspannungsanlage ist ein Geräuschsignal vorhanden, welchem sich im Fehlerfall die sehr hochfrequenten Teilentladungsimpulse überlagern. Die Signalverarbeitung ist deshalb vergleichsweise aufwendig. Sehr häufig wird deshalb das von einer der Elektroden 9,10 und 11 aufgenommene Messignal mit Hilfe eines von einer benachbarten bzw. von den beiden benachbarten Elektroden abgeleiteten Gating-Signals weiter verarbeitet. Es ist jedoch auch möglich, axial verschoben, unmittelbar neben den Elektroden 9,10 und 11 weitere, identisch ausgebildete Elektroden vorzusehen, mit deren Hilfe jeweils ein Gating-Signal generiert werden kann, welches dann zusammen mit dem Messignal, welches die jeweils zugeordnete der Elektroden 9,10 oder 11 liefert, verarbeitet wird. Die Signalverarbeitungsvorrichtung 28 ist so ausgelegt, dass sie mit Hilfe des Gating-Signals und mit Hilfe von entsprechend ausgelegten Filtern oder sonstigen elektronischen Baugruppen die hochfrequenten Teilentladungsimpulse von dem überlagerten Geräuschsignal trennen kann. Eine solche frühzeitige und einwandfreie Erkennung von Teilentladungsimpulsen hilft, die Betriebssicherheit der Hochspannungsanlage wesentlich zu erhöhen. Dank der frühzeitigen Erkennung der Störung, ist es möglich, eine Revision und, damit verbunden, eine Beseitigung der Ursache für die Teilentladungen einzuleiten, ehe die Teilentladungen sich ausweiten und zu grösseren Schäden an der Hochspannungsanlage führen können. Die Verfügbarkeit und die Wirtschaftlichkeit der Hochspannungsanlage wird dadurch vorteilhaft erhöht.

### BEZEICHNUNGSLISTE

- 1: Zentrum
- 2,3,4: Achsen
- 5,6,7: Phasenleiter
- 8: Kapselung
- 9,10,11: Elektroden
- 9a,b,10a,b,11a,b: Enden
- 12: Spalt
- 13,14,15: Anzapfungen
- 16,17,18: Messleitungen
- 19,20,21: Durchführungen
- 22,23,24: Vorverstärker
- 25,26,27: abgeschirmte Leitungen
- 28: Signalverarbeitungsvorrichtung
- 29: abgehende Leitung

## Patentansprüche

1. Sensor zum Auskoppeln von Teilentladungsimpulsen aus einer elektrischen Anlage, deren Aktivteile hochspannungsbeaufschlagt sind, insbesondere aus einer mit einer Kapselung (8) aus Metall versehenen gasisolierten Hochspannungsanlage, mit mindestens einer, dem jeweiligen Aktivteil der Anlage zugeordneten, dem elektromagnetischen Feld der Anlage ausgesetzten, Messelektrode, mit mindestens einer mit der Messelektrode verbundenen Signalverarbeitungsvorrichtung (28), dadurch gekennzeichnet,
- dass die Aktivteile mindestens drei symmetrisch auf drei Achsen (2,3,4) angeordnete Phasenleiter (5,6,7) umfassen,
- dass die Messelektrode ringförmig ausgebildet ist und in mindestens drei identische, voneinander beabstandete, als Elektroden (9,10,11) ausgebildete Segmente aufgeteilt ist, von denen jedes einem der Phasenleiter (5,6,7) zugeordnet ist,
- dass jede der mindestens drei Elektroden (9,10,11) mit der Signalverarbeitungsvorrichtung (28) verbunden ist, und
- dass die Signalverarbeitungsvorrichtung (28) Mittel aufweist, für das Ausfiltern von den ausgekoppelten Teilentladungsimpulsen überlagerten Störungen.

2. Sensor nach Anspruch 1, dadurch gekennzeichnet,
- dass die Elektroden (9,10,11) in ihrer geometrischen Mitte mit jeweils einer Anzapfung (13,14,15) versehen sind, und
- dass jede dieser Anzapfungen (13,14,15) als Seele in ein separates abgeschirmtes Koaxialkabel, vorzugsweise ein 50 Ohm-Kabel, eingeführt wird.

3. Sensor nach einem der Ansprüche 1 oder 2, dadurch gekennzeichnet,
- dass die Elektroden (9,10,11) jeweils zwei Enden (9a,9b,10a,10b,11a,11b) aufweisen, welche jeweils über ein Impedanzanpassungselement, insbesondere einen ohmschen Widerstand, elektrisch leitend mit der Kapselung (8) verbunden sind.

4. Sensor nach Anspruch 1, dadurch gekennzeichnet,
- dass die Oberflächen der Elektroden (9,10,11) aus für elektromagnetische Wellen unterschiedlich leitfähigem Material aufgebaut sind, wobei jeweils die Enden (9a,9b,10a,10b,11a,11b) eine geringere Leitfähigkeit für elektromagnetische Wellen aufweisen als die geometrische Mitte der Elektroden (9,10,11), wobei diese Leitfähigkeit von den Enden (9a,9b,10a,10b,11a,11b) her zur geometrischen Mitte hin stetig oder stufenweise zunimmt.

5. Sensor nach einem der Ansprüche 1 bis 4, dadurch gekennzeichnet,
- dass die Elektroden (9,10,11) symmetrisch zu den Achsen (2,3,4) angeordnet sind.

6. Sensor nach einem der Ansprüche 1 bis 5, dadurch gekennzeichnet,
- dass die Elektroden (9,10,11) in eine Vertiefung der Kapselung (8) eingelassen sind.
